(19) Europäisches Patentamt

European Patent Office

Office européen des brevets

(11) **EP 2 775 511 B1**

(12) **EUROPEAN PATENT SPECIFICATION**

(45) Date of publication and mention
of the grant of the patent:
**09.12.2020 Bulletin 2020/50**

(51) Int Cl.:
***H01L 23/373*** *(2006.01)*     ***H01L 23/482*** *(2006.01)*
***H01L 21/60*** *(2006.01)*

(21) Application number: **11875240.1**

(22) Date of filing: **31.10.2011**

(86) International application number:
**PCT/JP2011/075073**

(87) International publication number:
**WO 2013/065101 (10.05.2013 Gazette 2013/19)**

(54) **SEMICONDUCTOR DEVICE**

HALBLEITERBAUELEMENT

DISPOSITIF SEMI-CONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.09.2014 Bulletin 2014/37**

(73) Proprietor: **Hitachi, Ltd.
Tokyo 100-8280 (JP)**

(72) Inventors:
• **TANIE, Hisashi
Tokyo 100-8280 (JP)**
• **SHINTANI, Hiroshi
Tokyo 100-8280 (JP)**
• **TANAKA, Naotaka
Tokyo 100-8280 (JP)**

(74) Representative: **MERH-IP Matias Erny Reichl
Hoffmann
Patentanwälte PartG mbB
Paul-Heyse-Strasse 29
80336 München (DE)**

(56) References cited:
WO-A1-2005/086218    JP-A- 2007 531 243
JP-A- 2010 219 397    US-A1- 2002 159 236
US-A1- 2005 087 881    US-A1- 2006 279 932
US-A1- 2007 230 133    US-A1- 2010 196 659
US-B1- 6 411 513

• SUMIGAWA ET AL: "Disappearance of stress singularity at interface edge due to nanostructured thin film", ENGINEERING FRACTURE MECHANICS, PERGAMON PRESS, NEW YORK, NY, GB, vol. 75, no. 10, 28 December 2007 (2007-12-28), pages 3073-3083, XP022545406, ISSN: 0013-7944, DOI: 10.1016/J.ENGFRACMECH.2007.12.010

## Description

Technical Field

The present invention relates to technology that is effectively applied to reduction of thermal stress and improvement of heat radiation in a semiconductor device including a substrate and a semiconductor chip packaged on the substrate.

Background Art

As the background art of the field of the present technology, documents PTL 1, PTL 2, PTL 3, PTL 4, PTL 5, PTL 6, PTL 7, PTL 8 and NPL 1 are described below.

In PTL 1, as a solution to a problem "to prevent thermal breakdown of a semiconductor element due to a high temperature and generation of circuit characteristics resulting from a high load and interlayer film cracking in a thermocompression bonding process in which a high temperature and a high load are applied, by adopting a joining process technique in which joining is carried out at a low temperature under a low load", technology "in a semiconductor device including a semiconductor element 1 having metal bumps 3 formed on a plurality of pad electrode portions 2 and a packaging substrate 4 having wiring electrode portions 5, conductive elastic bodies 6 having conductivity and elasticity are formed on the wiring electrode portions 5 of the packaging substrate 4, the semiconductor element 1 is packaged on the packaging substrate 4 with the metal bumps 3 shoved into the conductive elastic bodies 6, and the metal bumps 3 and the wiring electrode portions 5 are electrically connected and fixed by an insulating junction layer 10" is described (refer to Abstract) .

In PTL 2, as a solution to a problem "to provide a semiconductor device and a manufacturing method thereof suitable for suppressing deterioration of connection reliability by thermal stress due to a thermal expansion coefficient difference of a semiconductor chip and a substrate and realizing high density packaging", technology "a minute conductive connecting portion of which a shape is controlled by a substrate processed finely and a patterning technique is formed to connect the semiconductor chip and the substrate. The semiconductor device has a structure in which an electrode pad of the semiconductor chip is connected to an electrode pad of the substrate through the conductive connecting portion having at least two bent portions and curved portions and an insulating sealing portion is sealed therebetween. The semiconductor device can alleviate the thermal stress by deforming the conductive connecting portion and the insulating sealing portion when the thermal stress is applied and improve connection reliability" is described.

In PTL 3, as a solution to a problem "to provide a semiconductor device and a manufacturing method thereof in which there are not restrictions on heat resistance of element materials to be connected, there are not deterioration of a function of the device and damages to elements due to stress, and there is not a short circuit of adjacent electrodes due to a contact of adjacent connecting portions", technology "a solid-state imaging element 10 includes a scanning circuit portion 12, a photoelectric converting portion 14, a micro-spring 16, and a connecting layer 18. The micro-spring 16 has one end fixed on a pixel electrode 30 by a metal or the like and is formed in a shape of a tongue curved upward. The micro-spring 16 contacts an electrode 42 of the side of the photoelectric converting portion in a state in which the micro-spring 16 is compressed in an allowable range and electrically connects the pixel electrode 30 and the electrode 42 of the side of the photoelectric converting portion. The connecting layer 18 structurally connects the scanning circuit portion 12 and the photoelectric converting portion 14" is described.

In NPL 1, a dynamic characteristic and a manufacturing method of a nano-structure layer used in the present invention are described.

Further, PTL 4 describes a thermal interface material which comprises a bulk polymer within which is embedded sub-micron composite material wires having Ag and carbon nanotubes. PTL 5 describes a structure for cooling an electronic device which includes a top layer disposed over the electronic device. The structure further includes a plurality of spring elements disposed between the top layer and the electronic device, wherein one of the spring elements comprises a spring portion and a fin portion. PTL 6 describes a thermally conductive interface device for use between two surfaces that can accommodate a range of gap distances and angular misalignment. PTL 7 describes a circuit module mounting structure and a method for mounting an IC chip in the circuit module. A heat conducting element including a plurality of thin plates is provided between a radiation plate of a heat sink unit and a surface of the IC chip. PTL 8 describes an electronic device which has a semiconductor chip, which has mutually opposing contact sides, of which one first contact side is electroconductively surface-bonded via a first, solid soldering-agent layer to a first metallic conductor part. The semiconductor chip is electroconductively surface-bonded on its second contact side facing opposite the first contact side via a second soldering-agent layer to a second metallic conductor part.

Citation List

Patent Literature

PTL 1: JP-A-2006-287091
PTL 2: JP-A-2003-188209
PTL 3: JP-A-2003-298012
PTL 4: US 2010/196659 A1
PTL 5: US 2006/279932 A1
PTL 6: US 6 411 513 B1

PTL 7: US 2002/159236 A1
PTL 8: US 2005/087881 A1

Non-Patent Literature

NPL 1: Sumigawa T. et. al., Disappearance of stress singularity at interface edge due to anostructured thin film, Engineering Fracture Mechanics 75 (2008) 3073-3083

Summary of Invention

Technical Problem

In a structure in which the semiconductor chip is packaged on the substrate, because different materials are combined and used, this generates thermal stress due to a thermal deformation difference of each member by a temperature change. If a used temperature range is expanded by diversification of use environments of semiconductor products, the generated thermal stress increases. For this reason, to prevent deterioration of reliability of the semiconductor products due to the thermal stress becomes a problem.

In addition, when the semiconductor products are operated, the semiconductor chip generates heat. If the temperature of the generated heat increases by an increase of a packaging density, a temperature rise of the semiconductor chip becomes remarkable and the efficiency deterioration of the semiconductor chip by the temperature rise and the damage of the member by the thermal stress are concerned about. Therefore, in a semiconductor packaging structure, suppressing of the temperature rise, that is, improvement of heat radiation becomes a problem.

An object of the invention is to provide a semiconductor packaging structure capable of realizing reduction of thermal stress and improvement of heat radiation and a manufacturing method thereof.

The above and other objects and novel characteristics of the invention will be apparent from the description of the present specification and the accompanying drawings.

Solution to Problem

A semiconductor device according to an aspect of the invention includes a substrate and a semiconductor chip as defined in claim 1. Further features of the present invention are defined in the appended claims.

Advantageous Effects of Invention Effects obtained by the invention can be simply described as follows.

A thermal deformation difference of each member forming a semiconductor device is absorbed by deformation of structures, so that thermal stress of the semiconductor device can be decreased.

According to the invention, a nano-structure layer in which a plurality of structures are two-dimensionally arranged is used, so that thermal resistance of the semiconductor device decreases and heat radiation can be improved.

Brief Description of Drawings

[Fig. 1] Fig. 1(a) is a cross-sectional view of a semiconductor device not forming part of the present invention, but useful for understanding the present invention and Fig. 1(b) is an enlarged cross-sectional view illustrating a part of Fig. 1(a).

[Fig. 2] Fig. 2(a) is a cross-sectional view of a semiconductor device to be a comparative example of the present invention and Fig. 2(b) is an enlarged cross-sectional view illustrating a part of Fig. 2(a).

[Fig. 3] Figs. 3(a) to 3(e) are overall views and end enlarged views illustrating a manufacturing method of a semiconductor device not forming part of the present invention, but useful for understanding the present invention.

[Fig. 4] Figs. 4(a) and 4(b) are cross-sectional views illustrating a manufacturing method of a semiconductor device following Figs. 3(a) to 3(e).

[Fig. 5] Figs. 5(a), 5(b), and 5(c) are diagrams illustrating effects of a semiconductor device not forming part of the present invention, but useful for understanding the present invention.

[Fig. 6] Figs. 6(a) and 6(b) are diagrams illustrating deformation and stress generated in a nano-structure not forming part of the present invention, but useful for understanding the present invention.

[Fig. 7] Fig. 7 is a graph illustrating a relation of a shear displacement amount and maximum stress of a nano-structure obtained from a stress analysis, the nano-structure not forming part of the present invention, but useful for understanding the present invention.

[Fig. 8] Fig. 8 is a graph illustrating a relation of a shear displacement amount and maximum stress in a nano-structure having a height of 10 $\mu$m, acquired from a result of Fig. 7.

[Fig. 9] Fig. 9 (a) is a plan view of a semiconductor device of a second example useful for understanding the present invention, but not forming part of the present invention, Fig. 9(b) is a cross-sectional view taken along the line A-A of Fig. 9(a), and Fig. 9(c) is an enlarged cross-sectional view of a part of Fig. 9(b).

[Fig. 10] Fig. 10(a) is a plan view of a semiconductor device of a third example useful for understanding the present invention, but not forming part of the present invention and Fig. 10(b) is a cross-sectional view taken along the line B-B of Fig. 10(b).

[Fig. 11] Figs. 11(a), 11(b), and 11(c) are diagrams illustrating effects of semiconductor devices 1 of the second and third examples.

[Fig. 12] Fig. 12 is a graph illustrating a result obtained by calculating a temperature change when a semiconductor chip repeats heat generation and a stop by a heat conduction analysis.

[Fig. 13] Fig. 13 is a graph illustrating temperature change amounts of a semiconductor device according to a comparative example and semiconductor devices according to second and third examples.

[Fig. 14] Figs. 14(a) and 14(b) are plan views illustrating manufacturing methods of semiconductor devices of the second and third examples and Figs. 14(c), 14(d), and 14(e) are overall views and end enlarged views illustrating the manufacturing methods of the semiconductor devices of the second and third examples.

[Fig. 15] Figs. 15(a) to 15(e) are overall views and end enlarged views illustrating manufacturing methods of semiconductor devices following Figs. 14(a) to 14(e).

[Fig. 16] Figs. 16(a) and 16(b) are cross-sectional views illustrating manufacturing methods of semiconductor devices following Figs. 15(a) to 15(e).

[Fig. 17] Fig. 17(a) is a plan view of a semiconductor device to be a fourth example useful for understanding the present invention, but not forming part of the present invention and Fig. 17(b) is a cross-sectional view taken along the line C-C of Fig. 17(a).

[Fig. 18] Fig. 18 is a cross-sectional view of a nano-structure layer used in a first example useful for understanding the present invention, but not forming part of the present invention.

[Fig. 19] Fig. 19 is a cross-sectional view of a nano-structure layer used in a fifth example useful for understanding the present invention, but not forming part of the present invention.

[Fig. 20] Fig. 20 is a cross-sectional view of a nano-structure layer used in a sixth example useful for understanding the present invention, but not forming part of the present invention.

[Fig. 21] Fig. 21 is a cross-sectional view of a nano-structure layer used in a seventh example useful for understanding the present invention, but not forming part of the present invention.

[Fig. 22] Figs. 22(a), 22(b), and 22 (c) are overall views and end enlarged views illustrating a manufacturing method of a nano-structure layer used in the seventh example.

[Fig. 23] Fig. 23 is a cross-sectional view of a nano-structure layer according to the present invention.

[Fig. 24] Figs. 24(a) to 24(d) are overall views and end enlarged views illustrating a manufacturing method of a nano-structure layer according to the present invention.

[Fig. 25] Fig. 25 is a cross-sectional view of a nano-structure layer used in an example useful for understanding the present invention, but not forming part of the present invention.

[Fig. 26] Fig. 26(a) is a cross-sectional view of a semiconductor device of an example useful for understanding the present invention, but not forming part of the present invention and Fig. 26(b) is an enlarged cross-sectional view illustrating a part of Fig. 26(a).

Description of Embodiments

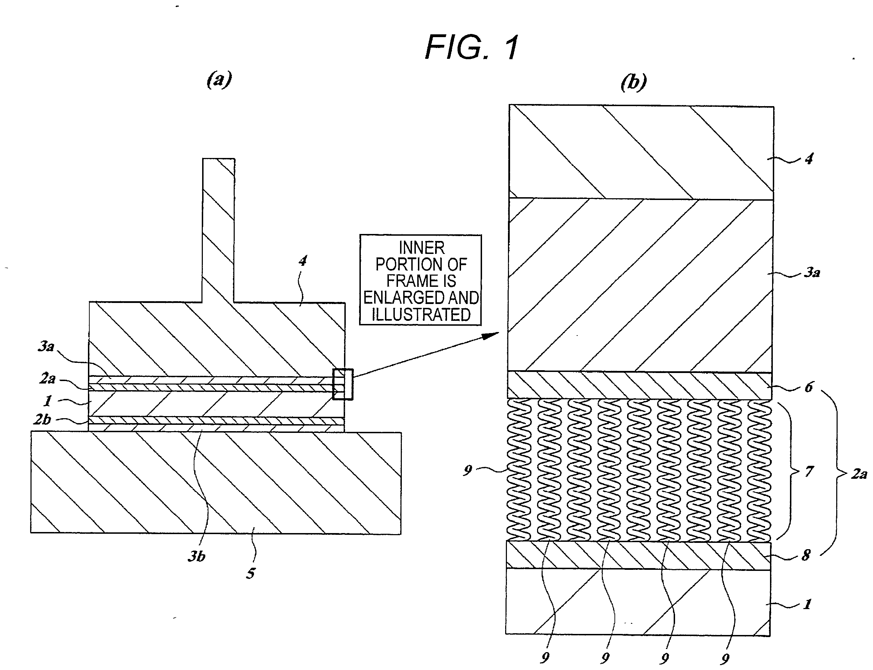

Hereinafter, embodiments of the present invention and examples useful for understanding the present invention will be described in detail on the basis of the drawings. In all of the drawings members having the same functions are denoted with the same reference numerals and repeated explanation thereof is omitted. In addition, in the embodiments, and examples, explanation of the same portions is not repeated in principle, except for the case in which the explanation is necessary. In addition, in the drawings hatching may be added in a plan view or the hatching may be omitted in a cross-sectional view to indicate a configuration. Even further, despite the general use of term "embodiment", the configurations or "embodiments" which include the zigzag shape of nano-structures 9 shall be considered as embodiments of the claimed subject-matter while the remaining "embodiments" shall be considered as "examples useful for the understanding of the invention". (First example useful for understanding the present invention) Fig. 1(a) is a cross-sectional view of a semiconductor device to be a first example useful for understanding the present invention and Fig. 1(b) is an enlarged cross-sectional view illustrating a part of Fig. 1(a).

The semiconductor device according to this example has a packaging structure in which a top surface of a semiconductor chip 1 on which a diode element is formed is electrically connected to a conductive member 4 through a deformation absorption layer 2a and a joining layer 3a and a bottom surface thereof is electrically connected to a conductive member 5 through a deformation absorption layer 2b and a joining layer 3b. The semiconductor device makes a current flowing from one of a pair of conductive members 4 and 5 to the inside rectified by the diode element in the semiconductor chip 1 and the current flow from the other of the conductive members 4 and 5 to the outside and has a function as a diode.

The semiconductor chip 1 is made of single crystal silicon made to have a diode function in a semiconductor manufacturing process (previous process) and has a side of about 6 mm and a thickness of about 0.2 mm as a dimension thereof .

Each of the deformation absorption layers 2a and 2b with the semiconductor chip 1 therebetween includes three kinds of different layers laminated along a thickness direction (vertical direction in the drawings). That is, each of the deformation absorption layers 2a and 2b includes a nano-structure layer 7 arranged at the center of the thickness direction and plate layers 6 and 8 of two layers with the nano-structure layer 7 therebetween, as illustrated in Fig. 1(b).

The nano-structure layer 7 has a structure in which nano-structures 9 having an approximately circular cross-sectional shape with a diameter of about 25 nm and a spring shape with an outer diameter of about 150 nm, an inner diameter of about 100 nm, and a pitch of about 50 nm are two-dimensionally arranged at an interval of about 170 nm. The height of the nano-structure 9 is 10 $\mu$m and a main material thereof is copper (Cu).

As such, each of the plurality of nano-structures 9 forming the nano-structure layer 7 has the spring shape having a size of nano-order, that is, 1 $\mu$m or less, so that stiffness of the nano-structure layer 7 decreases. Therefore, thermal stress due to a thermal deformation difference of each member forming the semiconductor device can be absorbed by deformation of the nano-structure layer 7.

In addition, the nano-structures 9 using the copper having high thermal conductivity as the main material are two-dimensionally arranged densely, so that thermal resistance of a thickness direction of the nano-structure layer 7 decreases. Thereby, because heat of the semiconductor chip 1 at the time of an operation can be diffused securely to the outside through the deformation absorption layers 2a and 2b, a temperate rise of the semiconductor chip 1 can be suppressed.

Both the joining layer 3a between the deformation absorption layer 2a and the conductive member 4 and the joining layer 3b between the deformation absorption layer 2b and the conductive member 5 are made of a solder material having a thickness of 50 $\mu$m. In addition, the conductive members 4 and 5 are made of the copper and have a function as an electrode to flow a current and a function as a radiator plate to emit the heat generated in the semiconductor chip 1 to the outside.

One end of each of the nano-structures 9 of the spring shapes forming the nano-structure layer 7 is fixed to the plate layer 6 and the other end thereof is fixed to the plate layer 8. Each of the plate layers 6 and 8 is made of a flat thin metal film having a thickness of about 5 $\mu$m and a main material thereof is nickel (Ni).

The nano-structures 9 are fixed to the plate layers 6 and 8, so that joining places of the nano-structure layer 7 and the joining layers 3a and 3b become flat surfaces . Thereby, joining of the nano-structure layer 7 and the joining layers 3a and 3b is facilitated and the joining layer 3a (or 3b) can be prevented from entering a gap of the nano-structure layer 7 at the time of the joining.

In addition, the plate layers 6 and 8 are configured using the nickel as a main material, so that surface oxidation of the plate layers 6 and 8 in the course of manufacturing the semiconductor device can be prevented. Therefore, defects such as an increase of contact resistance due to a surface oxidation layer can be prevented.

In this example, the nickel is used in the plate layers 6 and 8. However, when generation of the surface oxidation of the plate layers 6 and 8 in the manufacturing course is difficult, such as when a time from generation of the plate layer 8 to provision of the joining layers 3a and 3b is short or when the semiconductor device is manufactured in a vacuum environment, the copper can be used in the plate layers 6 and 8. Because the copper has thermal conductivity higher than thermal conductivity of the nickel, in this case, the thermal resistance can be decreased as compared with the case in which the nickel is used.

As such, it is a big characteristic of the present invention to provide the deformation absorption layers 2a and 2b having the nano-structure layer 7 between the semiconductor chip 1 and the conductive members 4 and 5.

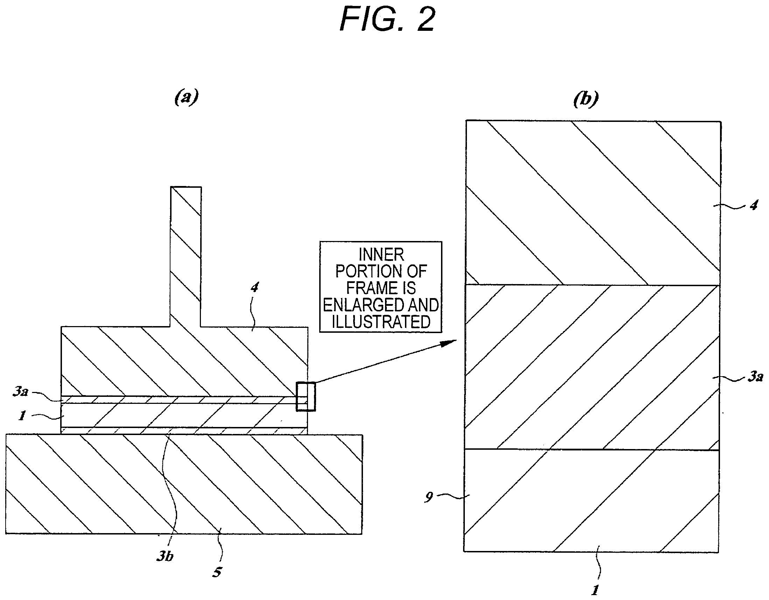

Fig. 2(a) is a cross-sectional view of a semiconductor device to be a comparative example of the present invention and Fig. 2 (b) is an enlarged cross-sectional view illustrating a part of Fig. 2(a).

The semiconductor device (comparative example) illustrated in Figs. 2(a) and 2(b) has a structure in which the deformation absorption layers 2a and 2b are removed from the semiconductor device according to this embodiment illustrated in Figs. 1(a) and 1(b) and the semiconductor chip 1 and the conductive members 4 and 5 are connected through only the joining layers 3a and 3b.

Because linear expansion coefficients of the conductive members 4 and 5 made of copper and the semiconductor chip 1 made of silicon are greatly different from each other, a thermal deformation difference of the conductive members 4 and 5 and the semiconductor chip 1 is large. For this reason, in the structure illustrated in Figs. 2(a) and 2(b), the thermal deformation difference of the semiconductor chip 1 and the conductive members 4 and 5 needs to be absorbed by the joining layers 3a and 3b arranged between the semiconductor chip 1 and the conductive members 4 and 5 and it is required that the joining layers 3a and 3b have materials having large thickness and small stiffness. Therefore, in the structure illustrated in Figs. 2 (a) and 2 (b), materials capable of being used as the joining layers 3a and 3b may be restricted and the thermal resistance may be increased by an increase in the thickness of the joining layers 3a and 3b.

In addition, when the thermal deformation difference of the semiconductor chip 1 and the conductive members 4 and 5 cannot be absorbed by the joining layers 3a and 3b, like the comparative example, defects such as cracks or malfunctions of the semiconductor chip 1 and destructions of the joining layers 3a and 3b may be generated. For this reason, in the related art, various structures such as forming the joining layers 3a and 3b of a multi-layered structure to improve a deformation absorption function or sealing the entire joining layers with a resin to decrease the thermal deformation difference of the semiconductor chip 1 and the conductive members 4 and 5 are suggested.

Meanwhile, in the semiconductor device according to this example illustrated in Figs. 1(a) and 1(b), the thermal deformation difference of the semiconductor chip 1 and the conductive members 4 and 5 is absorbed by the deformation absorption layers 2a and 2b including the nano-structure layer 7. Thereby, a packaging structure of high reliability that can prevent the defects such as the cracks or the malfunctions of the semiconductor chip 1 and the destructions of the joining layers 3a and 3b without taking measures such as multilayering of the joining layers 3a and 3b or resin sealing can be provided.

In addition, in the semiconductor device according to this example illustrated in Figs. 1(a) and 1(b), because the thermal deformation of each member is absorbed by the deformation absorption layers 2a and 2b, it is not necessary to give a deformation absorption function to the joining layers 3a and 3b. Thereby, because the thickness of the joining layers 3a and 3b can be decreased in a range in which the joining is enabled, the thermal resistance can be decreased as compared with the structure of Figs. 2 (a) and 2 (b) in which the joining layers 3a and 3b are formed thick to have the deformation absorption function.

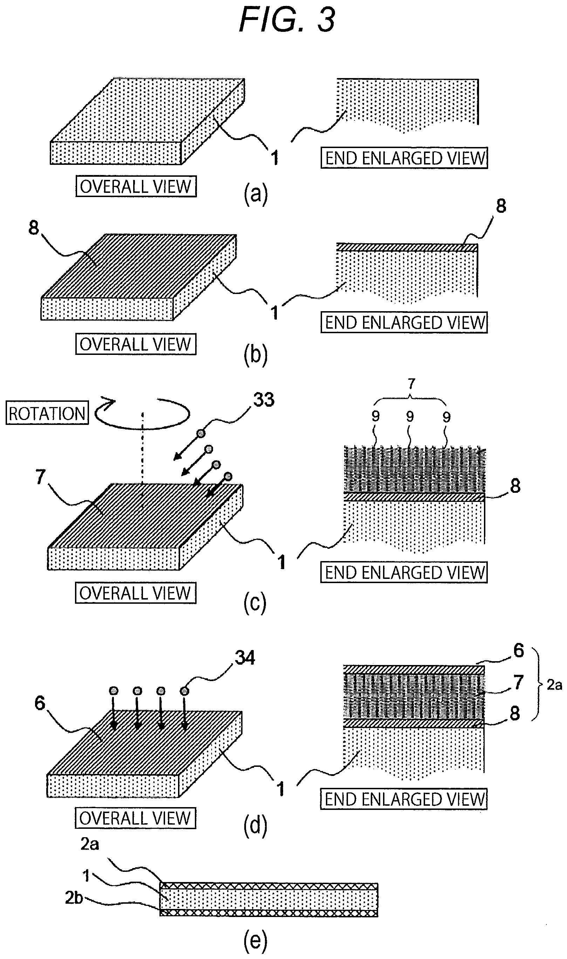

Next, a manufacturing method of the semiconductor device according to this example will be described with reference to Figs. 3(a) to 4(b).

First, the semiconductor chip 1 illustrated in Fig. 3 (a) is prepared. In the semiconductor chip 1, the diode element is formed by the semiconductor manufacturing process (previous process).

Next, as illustrated in Fig. 3(b), the plate layer 8 made of a nickel film is formed on a surface of the semiconductor chip 1 using a evaporation method. The plate layer 8 can be formed using a plating method, instead of the evaporation method. In addition, when a metal layer is formed on a surface of a semiconductor wafer by the semiconductor manufacturing process, the metal layer can be used as the plate layer 8.

Next, as illustrated in Fig. 3(c), while the semiconductor chip 1 is rotated about an axis vertical to the plate layer 8 under an approximately vacuum environment, copper atoms 33 are radiated from a direction oblique to the axis and are deposited. Thereby, the nano-structure layer 7 including the plurality of nano-structures 9 having the spring shapes of the nano-order is formed on the surface of the plate layer 8.

Next, after the rotation of the semiconductor chip 1 is stopped, as illustrated in Fig. 3(d), nickel atoms 34 are deposited from the upper side of the nano-structure layer 7, so that the plate layer 6 is formed on an upper portion of the nano-structure layer 7. By the previous process, the deformation absorption layer 2a including the plate layer 8, the nano-structure layer 7, and the plate layer 6 is formed on the surface of the semiconductor chip 1.

Next, the same sequence is executed after the surface and the back surface of the semiconductor chip 1 are reversed, so that the deformation absorption layer 2b including the plate layer 8, the nano-structure layer 7, and the plate layer 6 is formed on the back surface of the semiconductor chip 1 (Fig. 3(e)).

In the manufacturing method described above, after the semiconductor chip 1 is prepared by dicing the semiconductor wafer, the deformation absorption layers 2a and 2b are formed on both surfaces of the semiconductor chip 1. However, after the deformation absorption layers 2a and 2b are formed on both surfaces of the semiconductor wafer according to the above sequence, the semiconductor chip 1 may be separated by dicing the semiconductor wafer. In this case, the deformation absorption layers 2a and 2b can be formed collectively in the plurality of semiconductor chips 1 obtained from the semiconductor wafer. However, because it is necessary to give attention not to damage the deformation absorption layers 2a and 2b at the time of dicing the semiconductor wafer, it is desirable to select an appropriate method according to a dicing method.

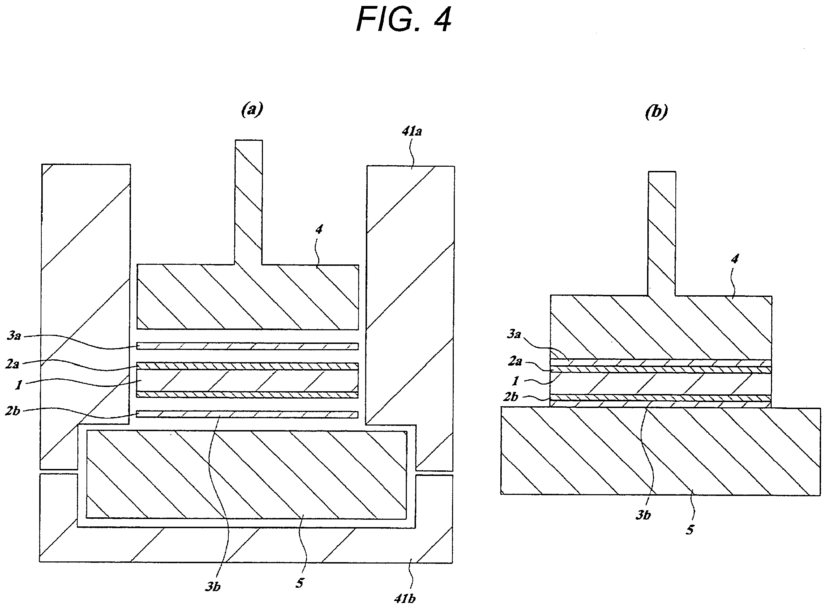

Next, as illustrated in Fig. 4(a), after the joining layer 3b, the semiconductor chip 1 on which the deformation absorption layers 2a and 2b are formed, the joining layer 3a, and the conductive member 4 are sequentially overlapped on the upper portion of the conductive member 5, a laminated object is exposed under an environment in which a temperature is equal to or more than a melting temperature of the solder material forming the joining layers 3a and 3b.

Thereby, the deformation absorption layer 2a and the conductive member 4 of the surface of the semiconductor chip 1 are joined through the joining layer 3a and the deformation absorption layer 2b and the conductive member 5 of the back surface of the semiconductor chip 1 are joined through the joining layer 3b.

At this time, in this embodiment, the laminated object is fixed by joining jigs 41a and 41b made of carbon to prevent a position deviation between the individual members forming the laminated object. In addition, at the time of the joining, the laminated object fixed by the joining jigs 41a and 41b is accommodated in a reflow furnace and is heated in an approximately vacuum environment, so that non-joining portions or voids generated in the joining layers 3a and 3b are decreased.

Then, an inner portion of the reflow furnace is cooled down and the laminated object is extracted from the joining jigs 41a and 41b, so that the semiconductor device according to this embodiment is finished (Fig. 4(b)).

According to the manufacturing method described above, the nano-structure layer 7 in which the plurality of nano-structures 9 having the spring shapes of the dimension of nano-order, that is, less than 1 μm are arranged densely can be manufactured. Therefore, a semiconductor packaging structure that is remarkably different from that in the related art can be realized.

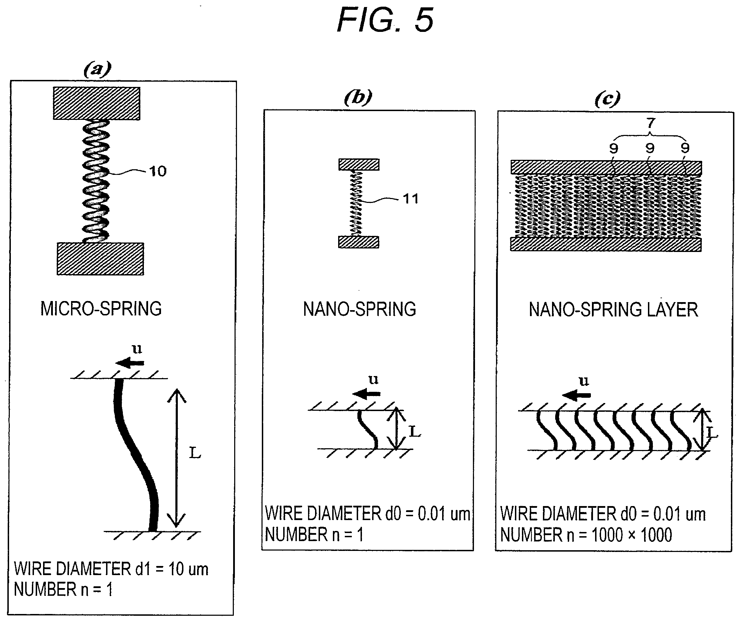

Next, characteristics of the semiconductor packaging structure according to other examples will be described. Fig. 5(a) illustrates a spring 10 having a dimension of micro-order in the related art, Fig. 5(b) illustrates a spring 11 of nano-order obtained by simply scaling down the spring illustrated in Fig. 5(a), and Fig. 5(c) illustrates the nano-structure layer 7 according to this example in which the nano-structures 9 having the spring shapes of the nano-order are arranged densely.

Because the deformation absorbed by the deformation absorption layers is mainly shear deformation, each of the springs is regarded as one needle to which the shear deformation is applied and the spring 10 of the micro-order, the spring 11 of the nano-order, and the nano-structure layer 7 are modeled as one needle having a wire diameter of 10 $\mu$m, one needle having a wire diameter of 10 nm, and 1000000 (= 1000 $\times$ 1000) needles having a wire diameter of 10 nm, respectively. The height of all the needles (the thickness of the nano-structure layer 7) is set as the same value L.

At this time, maximum stress ($\sigma_{max}$) generated in the needles is represented by the following expression:

[Mathematical Formula 1]

$$\sigma_{max} = \frac{3}{4}\frac{Edu}{L^2}$$

(in the expression, E shows longitudinal elasticity modulus, d shows a wire diameter, and u shows applied shear displacement).

From the expression, the stress generated in the nano-structure layer 7 and the spring 11 of the nano-order is the same. However, stress of 1000 times is generated in the spring 10 of the micro-order in which d is 1000 times and destruction prevention thereof becomes a problem.

Meanwhile, thermal resistance (R) is represented by the following expression:

[Mathematical Formula 2]

$$R = \frac{4L}{\lambda \pi d^2 n}$$

(in the expression, $\lambda$ shows thermal conductivity of a material and n shows a number).

From the expression, the thermal resistance of the nano-structure layer 7 and the spring 10 of the micro-order is the same. However, because the thermal resistance becomes 1000000 times in the spring 11 of the nano-order, a temperature rise of the semiconductor chip becomes remarkable. In order to make the stress generated in the spring 10 of the micro-order equal to the stress generated in the nano-structure layer 7, the height L needs to be set to 32 times. In this case, the thermal resistance becomes 32 times.

From this, it can be inferred that a function of realizing both the deformation absorption and the low thermal resistance required in the semiconductor packaging structure is a function that cannot be realized in the spring 10 of the micro-order according to the related art and the spring 11 of the nano-order obtained by simply scaling down the spring and can be realized first by the present invention.

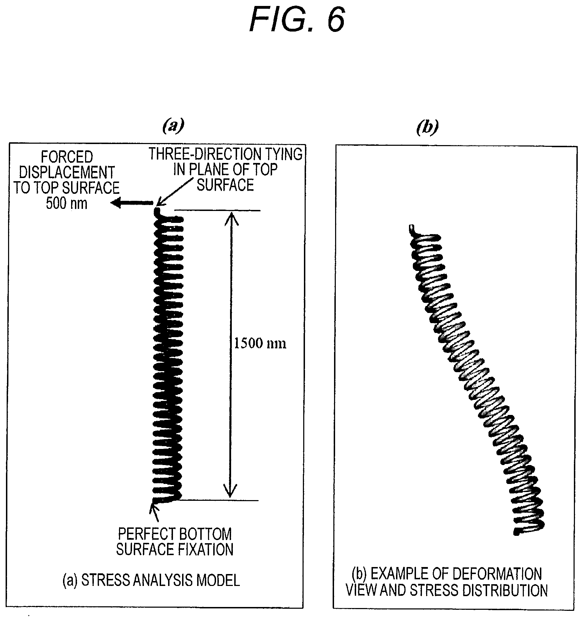

Fig. 6(a) illustrates a stress analyzing model of the nano-structure 9 according to this example. The actual height of the nano-structure 9 is 10 $\mu$m, but the height of 1500 nm is modeled herein. In addition, Fig. 6(b) illustrates an example of a deformation view and a stress distribution of the nano-structure 9 obtained by executing the stress analysis.

A dark place of Fig. 6 (b) is a place where stress is large . It can be known that the shear deformation is absorbed by the deformation of the entire spring and stress of both upper and lower ends is large as compared with a center portion.

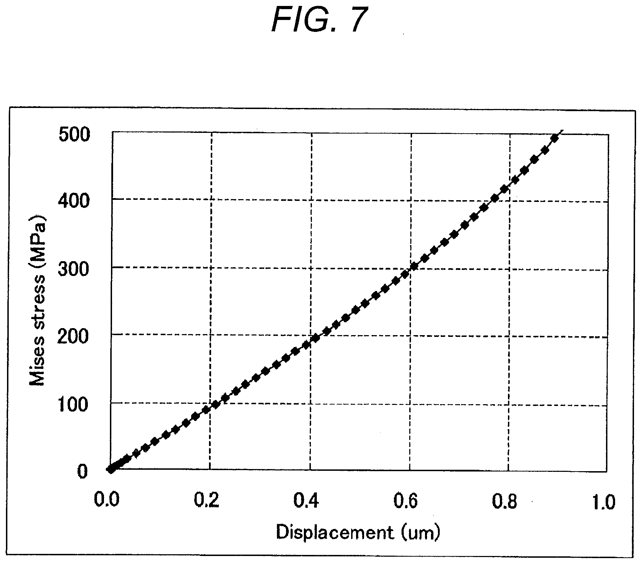

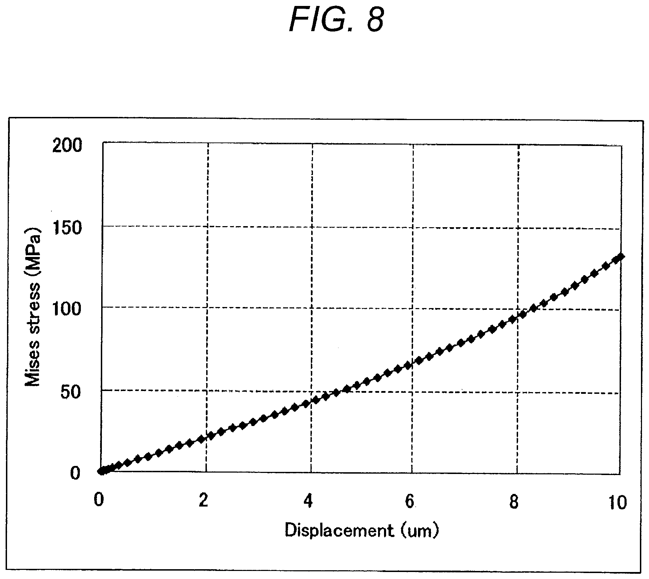

Fig. 7 is a graph illustrating a relation of a shear displacement amount (unit: pm) and maximum stress (unit: MPa) obtained from the stress analysis. In addition, Fig. 8 is a graph illustrating a relation of a shear displacement amount (unit: $\mu$m) and maximum stress (unit: MPa) in the nano-structure 9 having the height of 10 $\mu$m, acquired from a result of Fig. 7.

In the semiconductor device according to this example, the shear displacement amount is largest in the vicinity of the end of the semiconductor chip 1. The shear displacement amount at the corresponding position is 8.4 $\mu$m when a distance from the center of the semiconductor chip 1 is 3 mm, a linear expansion coefficient of the semiconductor chip 1 is 3 ppm/°C, a linear expansion coefficient of the conductive member is 17 ppm/°C, and a temperature change is 200°C.

From Fig. 8, it can be confirmed that, in the case of the nano-structure 9 having the height of 10 $\mu$m, the maximum stress generated in the shear displacement amount of 8.4 $\mu$m is about 100 MPa and is fatigue life satisfying the number of times required in the semiconductor device from fatigue strength of a copper material. The fatigue strength of the copper herein is described in "The society of materials science, Databook on fatigue strength of metallic materials, (1996), Elsevier Science".

Next, the thermal conductivity is confirmed. The thermal conductivity of the nano-structure layer 7 in a thickness direction becomes smaller than the thermal conductivity of copper of a bulk material, due to a space formed in the nano-structure layer 7 (small volume occupancy of the copper) and a long thermal conduction path for a spiral shape of the nano-structure 9.

Occupancy of the nano-structure 9 according to this embodiment in the volume of the nano-structure layer 7 is about 13%. If it is assumed that the thermal conductivity is decreased by one digit due to an increase in the conductivity path, the thermal conductivity of the nano-structure layer 7 in the thickness direction becomes about 1/100 of the thermal conductivity of the copper. This thermal conductivity is thermal conductivity of about 1/10 of the solder material used as the joining layers 3a and 3b. Therefore, the thermal resistance of the nano-structure layer 7 having the thickness of 10 μm is equal to the thermal resistance of the solder layer having the thickness of 100 μm and the thermal resistance of the nano-structure layer 7 does not become a remarkable problem. As illustrated by the comparison of Figs. 1(a) and 1(b) and Figs. 2 (a) and 2 (b), in the semiconductor packaging structure according to this example, the thickness of the joining layers 3a and 3b can be decreased. Therefore, if the thickness of the joining layers 3a and 3b can be decreased by 100 μm or more, the entire thermal resistance can be decreased.

As described above, it has been confirmed that the semiconductor device according to this example has the sufficient fatigue strength and the low thermal resistance.

(Second embodiment)

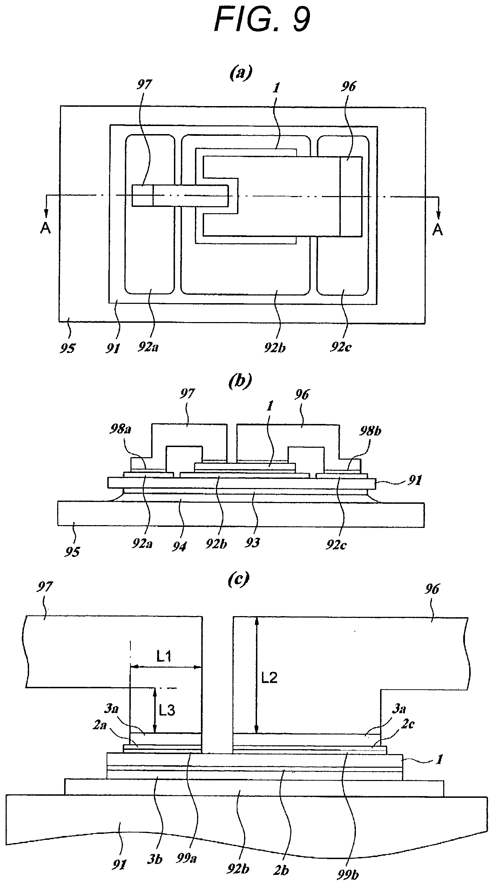

Fig. 9(a) is a plan view of a semiconductor device to be a second example useful for understanding the present invention, Fig. 9(b) is a cross-sectional view taken along the line A-A of Fig. 9(a), and Fig. 9(c) is an enlarged cross-sectional view illustrating a part of Fig. 9(b).

The semiconductor device according to this example has a structure in which a semiconductor chip 1 on which an insulated gate bipolar transistor (IGBT) is formed is packaged on a ceramic substrate 91. A plurality of circuit patterns 92a, 92b, and 92c are formed on a top surface of the ceramic substrate 91 and a metal pattern 93 is formed on a bottom surface thereof. The ceramic substrate 91 is joined to a top surface of a base member 95 through a joining material 94 arranged on a bottom surface of the metal pattern 93.

As illustrated in Fig. 9(c), a deformation absorption layer 2b is formed on a bottom surface of the semiconductor chip 1. The semiconductor chip 1 is electrically connected to the circuit pattern 92a through a joining layer 3b arranged on a bottom surface of the deformation absorption layer 2b. Meanwhile, a gate terminal 99a and an emitter terminal 99b of the IGBT are formed on a top surface of the semiconductor chip 1. In addition, the deformation absorption layer 2a is formed on an upper portion of the gate terminal 99a and the deformation absorption layer 2c is formed on an upper portion of the gate terminal 99b. In addition, the gate terminal 99a is electrically connected to one end of a gate terminal joining member 97 through the joining layer 3a arranged on an upper portion thereof and the emitter terminal 99b is electrically connected to one end of an emitter terminal joining member 96 through the joining layer 3b arranged on an upper portion thereof. In addition, as illustrated in Fig. 9(b), the other end of the gate terminal joining member 97 is electrically connected to the circuit pattern 92a through a joining material 98a and the other end of the emitter terminal joining member 96 is electrically connected to the circuit pattern 92c through a joining member 98b.

Although not illustrated in Figs. 9(a) to 9(c), each of the deformation absorption layers 2a, 2b, and 2c is configured to have the same structure as the deformation absorption layers 2a and 2b according to the above-described example. That is, each of the deformation absorption layers 2a, 2b, and 2c includes a nano-structure layer 7 and plate layers 6 and 8 of two layers with the nano-structure layer 7 therebetween and the nano-structure layer 7 has a structure in which a plurality of nano-structures 9 having spiral shapes are arranged densely. In addition, copper having high thermal conductivity is used in the circuit patterns 92a, 92b, and 92c, the emitter terminal joining member 96, and the gate terminal joining member 97, so that thermal resistance between the semiconductor chip 1 and the outside decreases.

An actual semiconductor device includes a terminal to take electrical connection of the circuit patterns 92a, 92b, and 92c and the outside, a case or a cover to protect the semiconductor device, and sealing gel to seal the semiconductor device, in addition to the members illustrated in Figs. 9(a) to 9(c). However, because these members do not affect the functions of the present invention, illustration and description thereof are omitted.

A large difference between the first embodiment and the second embodiment is that the plurality of terminals (the gate terminal 99a and the emitter terminal 99b) are provided on the top surface of the semiconductor chip 1 to make the semiconductor chip 1 have a function as the IGBT. For this reason, different from the first example, the plurality of deformation absorption layers 2a and 2c are arranged on the top surface of the semiconductor chip 1. In addition, the terminal joining members (the gate terminal joining member 97 and the emitter terminal joining member 96) having almost the same bottom surface dimension as a plane dimension of the terminals (the gate terminal 99a and the emitter terminal 99b) are connected to the upper portions of the deformation absorption layers 2a and 2c, so that heat generated from the semiconductor chip 1 at the time of an operation can be effectively emitted from not only the bottom surface side of the semiconductor chip 1 but also the top surface side thereof.

The terminal joining members (the gate terminal joining member 97 and the emitter terminal joining member 96) have large length and large stiffness. For this reason, when the deformation absorption layers 2a and 2c are not provided, reliability deterioration of the joining layer 3a due to a thermal deformation difference of the semiconductor chip 1 and the terminal joining members (the gate terminal joining member 97 and the emitter terminal joining member 96) becomes a problem. Therefore, in this case, members having a small size and small stiffness like wire are generally used in electrical connection of the terminals (the gate terminal 99a and the emitter terminal 99b) and the circuit patterns 92a, 92b, and 92c.

However, according to this example, because the thermal deformation difference of the semiconductor chip 1 and the terminal joining members (the gate terminal joining member 97 and the emitter terminal joining member 96) is absorbed by the deformation absorption layers 2b and 2c, high reliability can be secured and the thermal resistance between the semiconductor chip 1 and the terminal joining members (the gate terminal joining member 97 and the emitter terminal joining member 96) can be decreased.

If a place having a small cross-sectional area exists in a part of the terminal joining members (the gate terminal joining member 97 and the emitter terminal joining member 96), a position thereof becomes a narrow path of a heat radiation path. Therefore, in this example, the shapes of the terminal joining members (the gate terminal joining member 97 and the emitter terminal joining member 96) are determined to become bigger than the shape of the terminal (in this case, the gate terminal 99a) having a small area. In addition, in this example, as illustrated in Fig. 9(c), a constant gap L3 is provided between an outer circumferential portion of the semiconductor chip 1 and the terminal joining members (the gate terminal joining member 97 and the emitter terminal joining member 96), so as to prevent a contact of the outer circumferential portion of the semiconductor chip 1 and the terminal joining members (the gate terminal joining member 97 and the emitter terminal joining member 96).

From this, the height L2 of the terminal joining members (the gate terminal joining member 97 and the emitter terminal joining member 96) in the upper portion of the semiconductor chip 1 becomes larger than a connection width L1 of the gate terminal joining member 97 and the gate terminal 99a.

(Third embodiment)

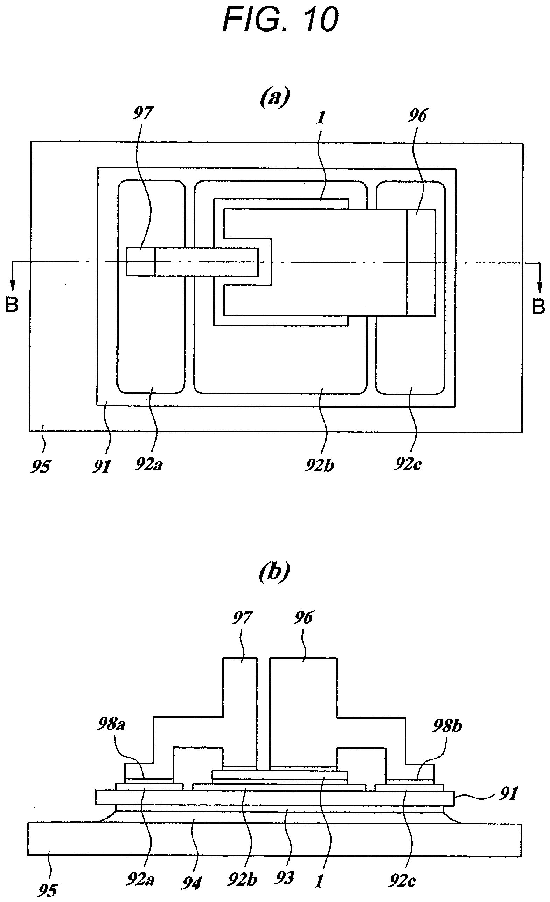

Fig. 10(a) is a plan view of a semiconductor device to be a third example useful for understanding the present invention and Fig. 10(b) is a cross-sectional view taken along the line B-B of Fig. 10(a).

Similar to the semiconductor device according to the second example, the semiconductor device according to this example has a structure in which a semiconductor chip 1 on which an IGBT is formed is packaged on a ceramic substrate 91. However, this example is different from the second example in that heights of terminal joining members (a gate terminal joining member 97 and an emitter terminal joining member 96) in an upper portion of the semiconductor chip 1 become larger than heights of the other places.

In this case, because volumes of the terminal joining members (the gate terminal joining member 97 and the emitter terminal joining member 96) in the vicinity of the semiconductor chip 1 increase, heat capacities of the terminal joining members in the vicinity of the semiconductor chip 1 increase. Therefore, a temperature change of the semiconductor chip 1 when the semiconductor chip 1 repeats an operation and a stop can be decreased, a stabilized operation can be secured, and thermal fatigue life can be further improved.

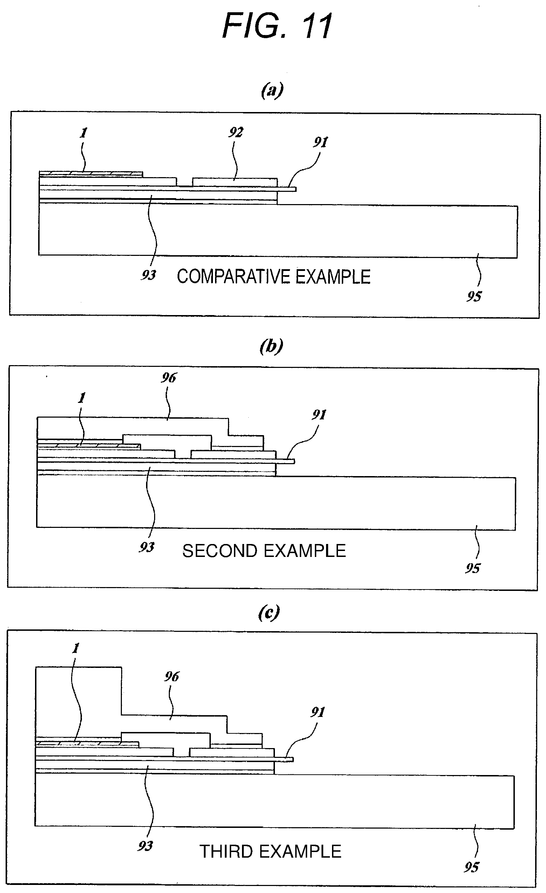

Next, effects of the second and third examples will be described using Figs. 11(a) to 12. Fig. 11(a) is a partial cross-sectional view illustrating a structure according to a comparative example in which deformation absorption layers 2b and 2c and the terminal joining members (the gate terminal joining member 97 and the emitter terminal joining member 96) are not provided and Fig. 11(b) is a partial cross-sectional view illustrating a structure according to the second example, and Fig. 11(c) is a partial cross-sectional view illustrating a structure according to a third example

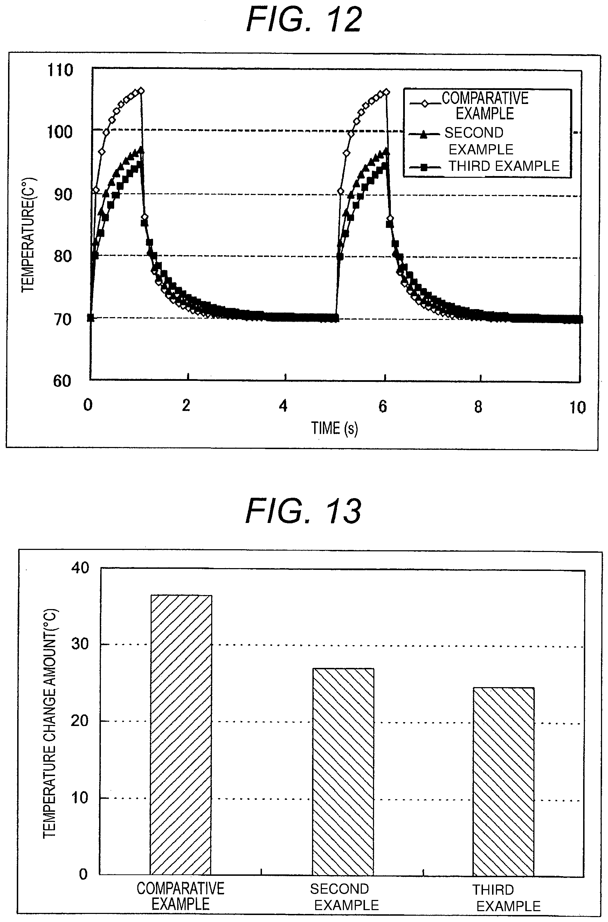

In these structures, the temperature change of the semiconductor chip 1 when the semiconductor chip 1 repeats the heat generation and the stop is calculated by a thermal conduction analysis. In addition, conditions in which cooling water of 70°C is flown to a bottom surface of a base member 95 and heat of the semiconductor chip 1 is emitted from the side of the bottom surface of the base member 95 are set. A calculation result is illustrated in Fig. 12.

In all the structures, an amount of heat generated from the semiconductor chip 1 at the time of heat generation is the same. However, a temperature of the semiconductor chip 1 is significantly different according to the structure. That is, the temperature of the semiconductor chip 1 when the heat generation ends is high in order of the structure according to the comparative example, the structure according to the second example, and the structure according to the third example.

Fig. 13 illustrates a temperature change amount of each structure. A temperature change amount of the structure according to the comparative example is 36°C, but temperature change amounts of the structures according to the second and third examples are 27°C and 24°C, respectively, and are decreased to 75% and 67%, respectively, for the structure according to the comparative example. As such, it can be confirmed that the temperature change of the semiconductor chip 1 can be decreased by using the structure according to the second example or the third example.

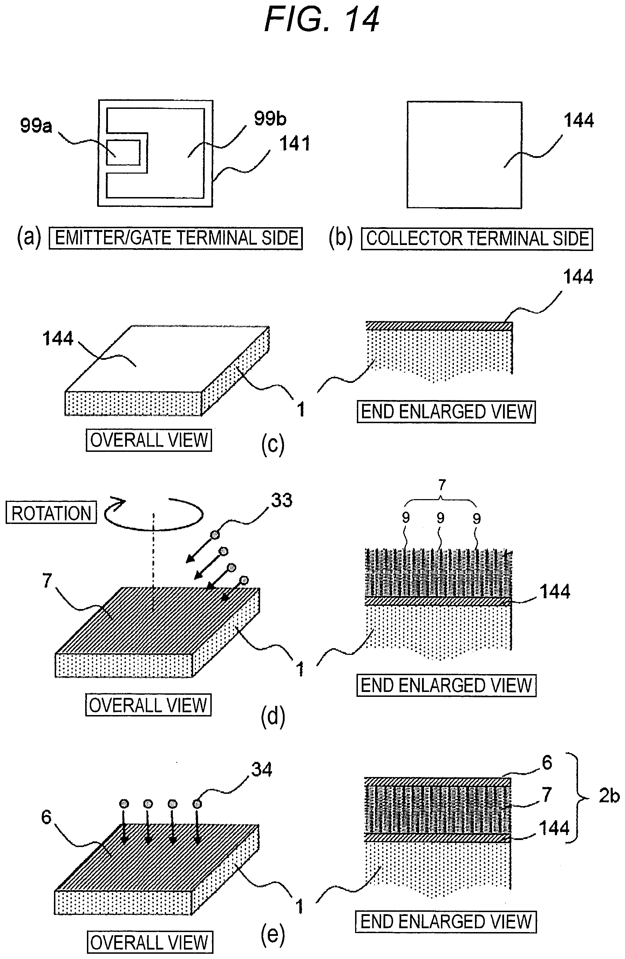

Next, manufacturing methods of the semiconductor devices according to the second and third examples will be described using Figs. 14(a) to 16(b).

First, the semiconductor chip 1 illustrated in Figs. 14(a), 14(b), and 14(c) is prepared. As illustrated in Fig. 14(a), the gate terminal 99a connected to a gate of the IGBT and the emitter terminal 99b connected to an emitter of the IGBT are formed on the top surface of the semiconductor chip 1. As illustrated in Figs. 14(b) and 14(c), a collector terminal 144 connected to a collector of the IGBT is formed on the bottom surface of the semiconductor chip 1. The gate terminal 99a and the emitter terminal 99b are formed on the top surface of the semiconductor wafer by a semiconductor manufacturing process (previous process) and the collector terminal 144 is formed on the bottom surface of the semiconductor wafer by the semiconductor manufacturing process.

Next, as illustrated in Fig. 14(d), the nano-structure layer 7 including the plurality of nano-structures 9 having the spring shapes of the nano-order is formed on a surface of the collector terminal 144 of the semiconductor chip 1. A method of forming the nano-structure layer 7 is the same as the method according to the first embodiment described in Fig. 3(c). While the semiconductor chip 1 is rotated about an axis vertical to the collector terminal 144 under an approximately vacuum environment, copper atoms 33 are deposited from a direction oblique to the axis.

Next, after the rotation of the semiconductor chip 1 is stopped, as illustrated in Fig. 14(e), nickel atoms 34 are deposited from the upper side of the nano-structure layer 7, so that the plate layer 6 is formed on an upper portion of the nano-structure layer 7. By the previous process, the deformation absorption layer 2b including the collector terminal 144, the nano-structure layer 7, and the plate layer 6 is formed on the surface of the semiconductor chip 1.

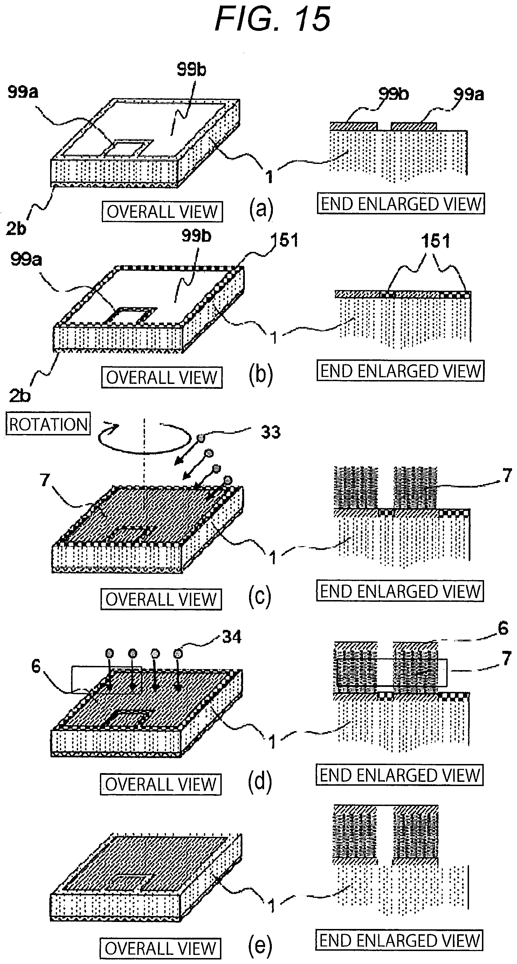

Next, as illustrated in Fig. 15 (a), the surface and the back surface of the semiconductor chip 1 are reversed to make the surface on which the gate terminal 99a and the emitter terminal 99b are formed become the upper side. Then, as illustrated in Fig. 15(b), a mask 151 made of an insulating material is formed in a region other than the surface of the emitter terminal 99a and the surface of the gate terminal 99b in the top surface of the semiconductor chip 1.

At this time, it is desirable to make the thickness of the mask 151 equal to the thickness of the gate terminal 99a and the emitter terminal 99b. This is because, in the case in which the thickness of the mask 151 and the thickness of the gate terminal 99a and the emitter terminal 99b are different from each other, when the atoms constituting the nano-structure are deposited from an oblique direction in a next process, position precision of the deposited atoms is deteriorated.

Next, as illustrated in Fig. 15(c), while the semiconductor chip 1 is rotated about an axis vertical to the plate layer 8 under an approximately vacuum environment, the copper atoms 33 are deposited from a direction oblique to the axis. Thereby, the nano-structure layer 7 including the plurality of nano-structures 9 having the spring shapes of the nano-order is formed on the surface of the gate terminal 99a and the surface of the emitter terminal 99b. At this time, the nano-structure 9 is not formed on the surface of the mask 151 made of the insulating material.

Next, after the rotation of the semiconductor chip 1 is stopped, as illustrated in Fig. 15 (d), the nickel atoms 34 are deposited from the upper side of the nano-structure layer 7, so that the plate layer 6 is formed on an upper portion of the nano-structure layer 7. At this time, the plate layer 6 is not formed on the surface of the mask 151 not having the nano-structure 9.

Next, as illustrated in Fig. 15 (e), the mask 151 of the top surface of the semiconductor chip 1 is removed, so that the deformation absorption layer 2a including the gate terminal 99a, the nano-structure layer 7, and the plate layer 6 and the deformation absorption layer 2c including the emitter terminal 99b, the nano-structure layer 7, and the plate layer 6 are formed.

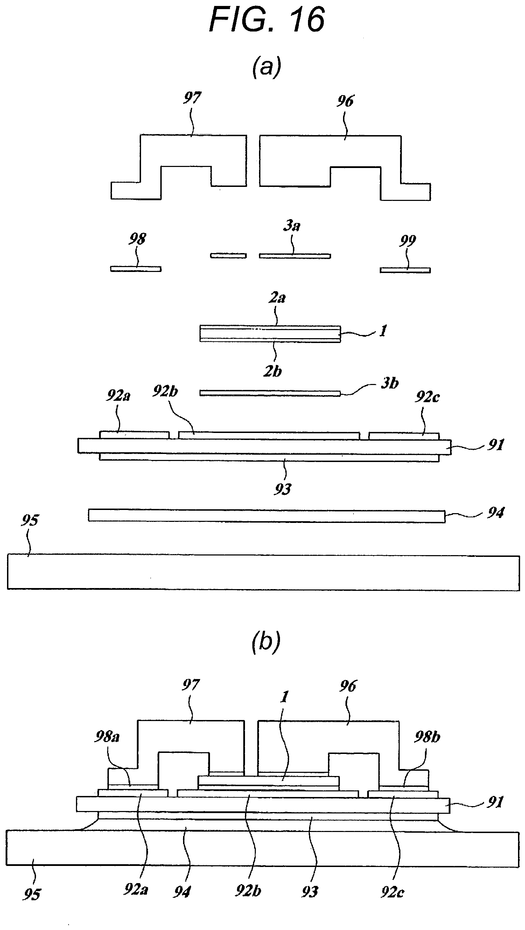

Next, as illustrated in Fig. 16(a), each member is laminated and a temperature is increased to a temperature equal to or more than a melting point of the joining layer 3. Thereby, as illustrated in Fig. 16(b), the semiconductor device according to the second example or the third example is finished. At this time, it is desirable to fix each member using joining jigs (not illustrated in the drawings) to prevent the position deviation of each member before the joining, similar to the manufacturing method according to the first example. (Fourth example useful for understanding the present invention)

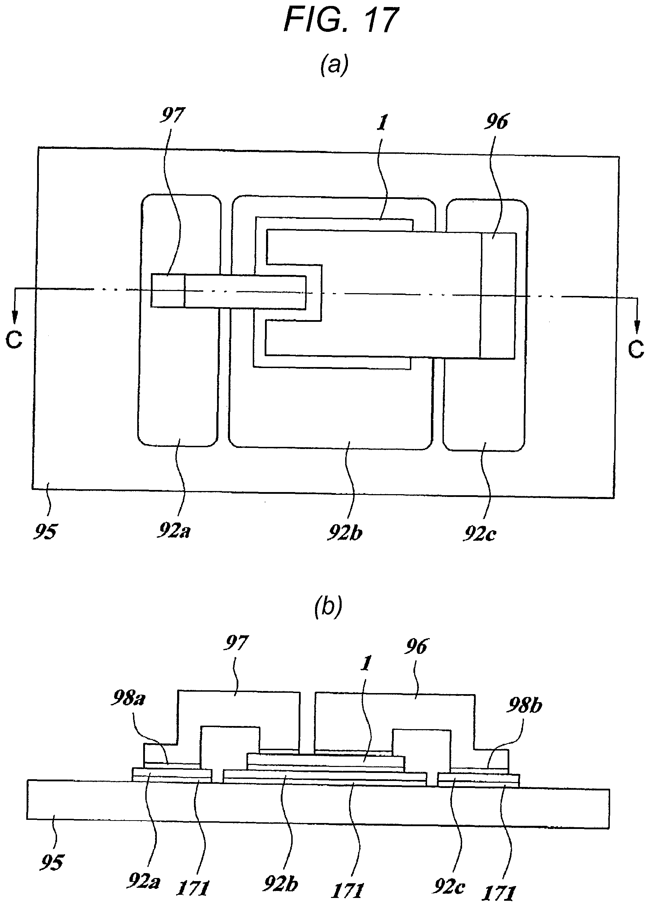

Fig. 17(a) is a plan view of a semiconductor device to be a fourth example of the present invention and Fig. 17 (b) is a cross-sectional view taken along the line C-C of Fig. 17(a).

Similar to the semiconductor devices according to the second and third examples, the semiconductor device according to this example uses a semiconductor chip 1 on which an IGBT is formed. A difference of the fourth example and the second and third examples is that circuit patterns 92a, 92b, and 92c and a base member 95 are connected through a nano-structure layer 171 in which a plurality of nano-structures made of an insulating material such as ceramic are two-dimensionally arranged.

According to a packaging structure according to this example, insulation of the base member 95 and the circuit patterns 92a, 92b, and 92c can be secured without using the ceramic substrate 91, the metal pattern 93, and the joining material 94 used in the second and third examples.

In addition, because a thermal deformation difference of the base 91 and the circuit patterns 92a, 92b, and 92c is absorbed by the nano-structure layer 171 made of the ceramic material, a semiconductor device having high reliability can be provided. (Fifth example useful for understanding the present invention)

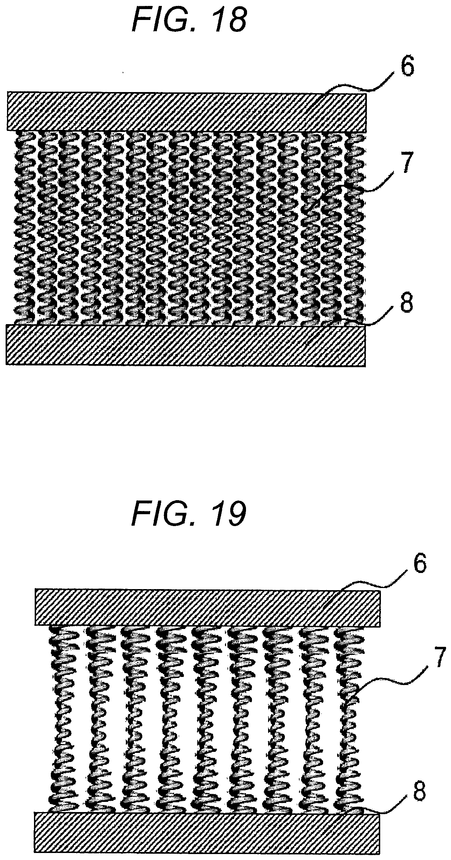

As illustrated in Fig. 18, the nano-structure layer 7 used in the first example has the structure in which the nano-structures 9 having the spring shapes are two-dimensionally arranged and a diameter of each nano-structure 9 is the same in an upper end, a center portion, and a lower end.

Meanwhile, the diameter of the center portion of the nano-structure 9 used in this example is smaller than the diameters of both the upper and lower ends, as illustrated in Fig. 19. The nano-structure 9 having the above shape can be manufactured by changing a rotation number of the semiconductor chip 1 in the middle of the rotation, in the manufacturing process of the nano-structure layer 7 according to the first example illustrated in Fig. 3 (c) .

As described using Figs. 6 (a) and 6(b), if forced displacement of a shear direction is applied to the nano-structure 9 having the spring shape, large stress is generated in both the upper and lower ends of the nano-structure 9 rather than the center portion. Therefore, the nano-structure 9 according to this example illustrated in Fig. 19 is used, so that stiffness of the spring decreases in the center portion of the nano-structure 9 having the small diameter and displacement absorbed at the corresponding position increases. As a result, maximum stress generated in both the upper and lower ends of the nano-structure 9 can be decreased.

The nano-structure 9 according to this example is used in combination with the first to fourth examples, so that a semiconductor device having improved reliability can be provided. (Sixth example useful for understanding the present invention)

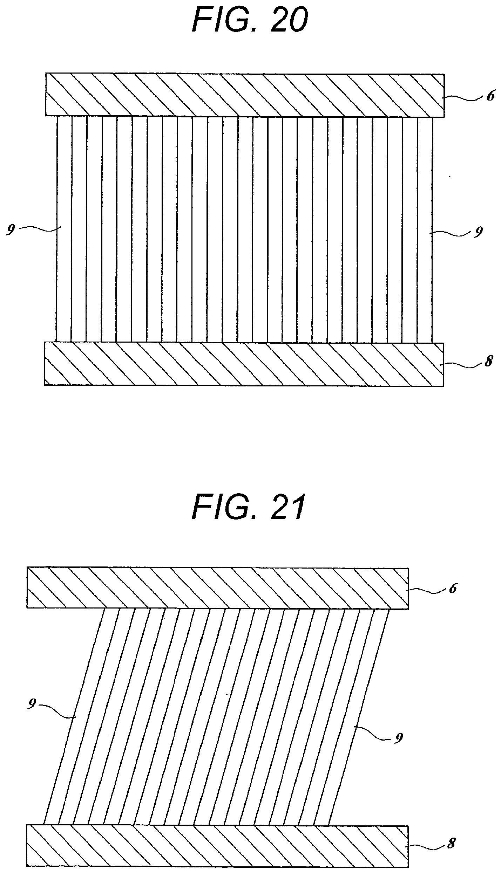

The nano-structure layer 7 used in the first to fifth examples has the structure in which the nano-structures 9 having the spring shapes are two-dimensionally arranged. Meanwhile, a nano-structure layer 7 according to this example has a structure in which nano-structures 9 having columnar shapes are two-dimensionally arranged, as illustrated in Fig. 20. The nano-structure 9 having the above shape can be manufactured by increasing the rotation speed of the semiconductor chip 1 and coupling springs along a vertical direction, in the manufacturing process of the nano-structure layer 7 according to the first example illustrated in Fig. 3(c).

In the nano-structure 9 according to this example a deformation absorption function is inferior as compared with the nano-structures 9 according to the first to fifth examples having the spring shapes. However, because the heat capacity is large as compared with the nano-structures 9 having the spring shapes, thermal conductivity of a height direction is improved.

In addition, because volume occupancy of the nano-structure 9 can be increased as compared with the nano-structure layers 7 according to the first to fifth examples, thermal resistance or electrical resistance of the nano-structure layer 7 can be further decreased. Therefore, the nano-structure 9 according to this embodiment can be used effectively for a product in which thermal resistance reduction is further required. (Seventh example useful for understanding the present invention)

As illustrated in Fig. 21, a nano-structure layer 7 according to this example is characterized in that each of nano-structures 9 has an inclination for facing surfaces with a plate layer 6 and a plate layer 8. The nano-structure layer 7 having the nano-structures 9 of the above shape can be manufactured by a next method.

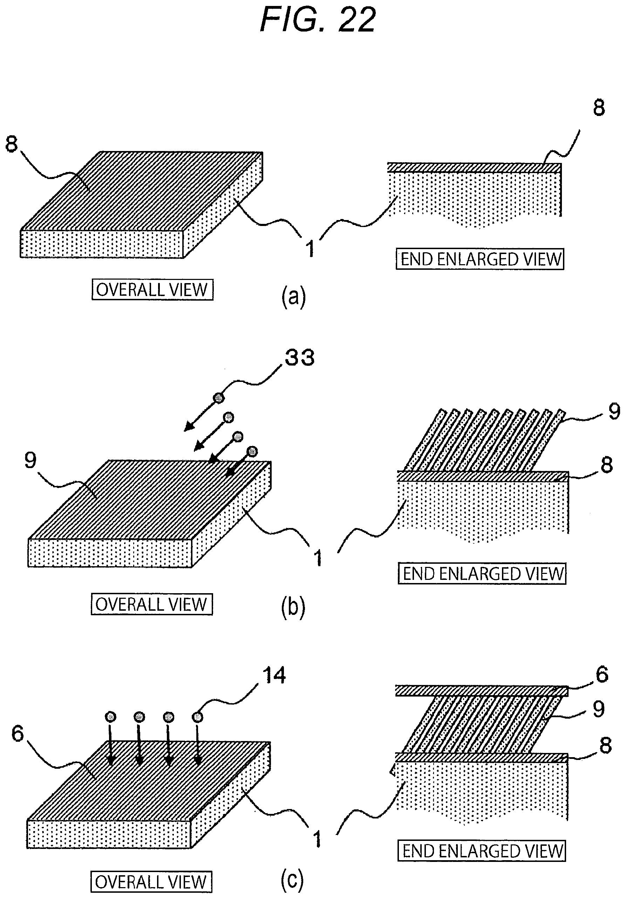

First, as illustrated in Fig. 22 (a), a semiconductor chip 1 of which a top surface is provided with the plate layer 8 is prepared. Next, as illustrated in Fig. 22 (b), copper atoms 33 are deposited from a direction oblique to a top surface of the plate layer 8, under an approximately vacuum environment. A manufacturing method according to this example is different from the manufacturing methods according to the other examples in that the atoms 33 are deposited without rotating the semiconductor chip 1 at that time. Therefore, in this embodiment, a deposition device does not need to have a function of rotating the semiconductor chip 1.

Then, as illustrated in Fig. 22 (c), nickel atoms 34 are deposited from the upper side of the nano-structure layer 7, so that the plate layer 6 is formed on an upper portion of the nano-structure layer 7.

In the nano-structure layer 7 according to this example manufactured by the above method, because the nano-structures 9 are not formed in a part of a top surface of the plate layer 8 or a part of a bottom surface of the plate layer 6, electrical conductivity or thermal conductivity of the nano-structure layer 7 is slightly decreased as compared with the other examples (Embodiment of the present invention)

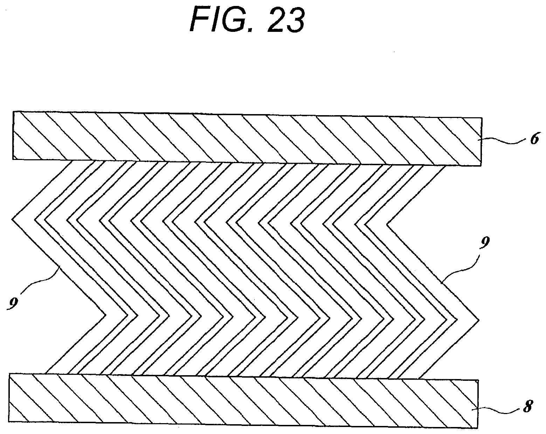

As illustrated in Fig. 23, a nano-structure layer 7 according to this embodiment has a structure in which nano-structures 9 having different inclinations for a top surface of a plate layer 8 and having zigzag shapes are two-dimensionally arranged. The nano-structure layer 7 having the nano-structures 9 of the above shapes can be manufactured by a next method.

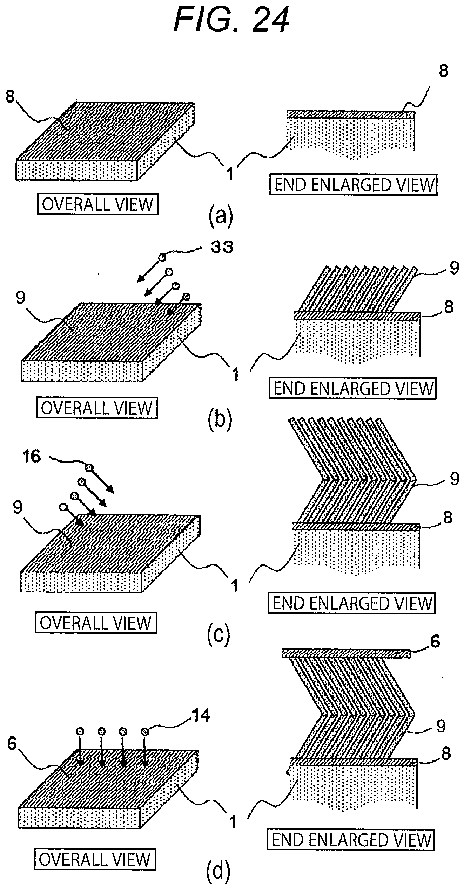

First, as illustrated in Fig. 24 (a), a semiconductor chip 1 of which a top surface is provided with the plate layer 8 is prepared. Next, as illustrated in Fig. 24 (b), copper atoms 33 are deposited from a direction oblique to a top surface of the plate layer 8, under an approximately vacuum environment. At this time, the atoms 33 are deposited without rotating the semiconductor chip 1, similar to the seventh example

Next, as illustrated in Fig. 24(c), the semiconductor chip 1 is rotated by 180° and the copper atoms 33 are deposited from the oblique direction according to the same sequence as the above case. Then, as illustrated in Fig. 24(c), nickel atoms 34 are deposited from the upper side of the nano-structure layer 7, so that the plate layer 6 is formed on an upper portion of the nano-structure layer 7.

Here, the semiconductor chip 1 is rotated only once. However, work illustrated in Fig. 24(b) and work illustrated in Fig. 24(c) are repeated by the necessary number of times, so that the zigzag shapes of the nano-structures 9 can be controlled.

According to the manufacturing method according to this embodiment, when the atoms 33 constituting the nano-structures 9 are deposited, the semiconductor chip 1 does not need to be rotated at all times. In addition, the problem according to the seventh example in that the nano-structures 9 are not formed in the part of the top surface of the plate layer 8 or the part of the bottom surface of the plate layer 6 can be resolved. In addition, because volume occupancy of the nano-structures 9 can be increased as compared with the nano-structure layers 7 according to the first to fifth examples, thermal resistance or electrical resistance of the nano-structure layer 7 can be further decreased. (Ninth example useful for understanding the present invention)

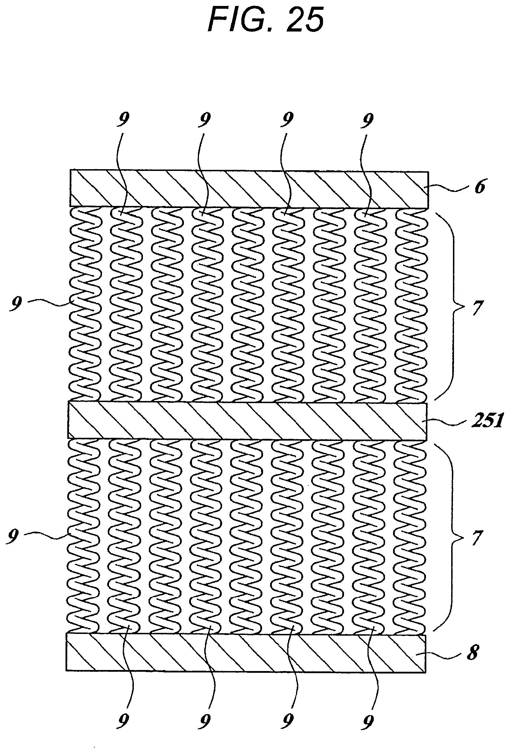

As illustrated in Fig. 25, a semiconductor device according to this example is characterized in that a plurality of nano-structure layers 7 are laminated with an intermediate plate layer 251 therebetween. Fig. 25 illustrates an example of the case in which the nano-structure layers 7 of two layers are laminated. However, formation of the nano-structure layer 7 and formation of the intermediate plate layer 25 may be alternately repeated to laminate the nano-structure layers 7 of three layers or more. In addition, shapes of nano-structures 9 are not limited to the spring shapes and the nano-structures 9 may be the nano-structures 9 according to the sixth to eighth examples.

In the case in which the nano-structure layers 7 according to this example are laminated in n steps, because deformation absorbed by each nano-structure layer 7 is decreased to 1/n, larger deformation can be absorbed. Meanwhile, because entire thermal resistance or electrical resistance of the nano-structure layer 7 becomes n times, it is desirable to select the number of nano-structure layers 7 laminated according to required deformation absorption ability, thermal resistance, and electrical resistance. (Tenth example useful for understanding the present invention)

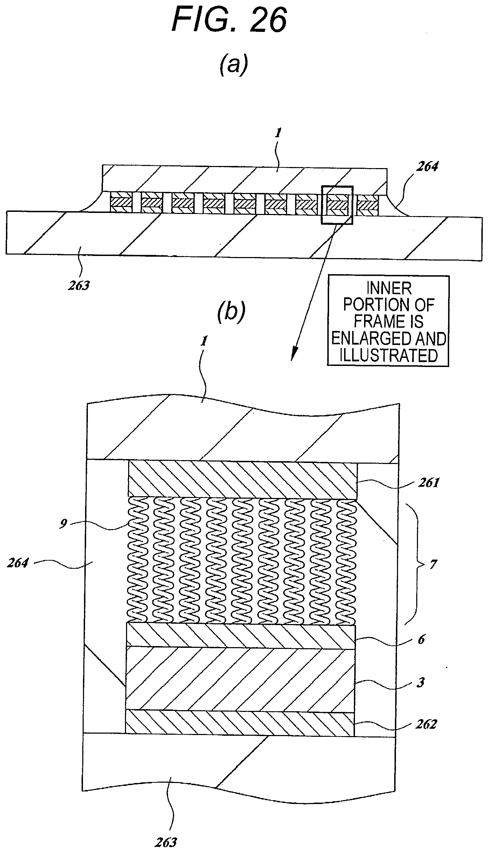

As illustrated in Figs. 26 (a) and 26 (b), a semiconductor device according to this example has a structure in which a semiconductor chip 1 is flip-chip bonded to a surface of a package substrate 263 functioning as a substrate and each of a plurality of flip-chip bonding portions to electrically connect the package substrate 263 and the semiconductor chip 1 includes a nano-structure layer 7. The nano-structure layer 7 is formed by two-dimensionally arranging a plurality of structures made of a conductive material.

A plurality of chip-side lands 261 are provided on a surface (in the drawing, a bottom surface) of the semiconductor chip 1. In addition, in a region facing the chip-side lands 261 in a top surface of the package substrate 263, a plurality of substrate-side lands 262 are provided. In addition, the nano-structure layer 7, a plate layer 6, and a joining layer 3 are provided between the chip-side lands 261 and the substrate-side lands 262. In addition, an underfill resin 264 to seal the plurality of flip-chip bonding portions is filled into gaps of the plurality of flip-chip bonding portions. The nano-structure layer 7 is formed by two-dimensionally arranging the plurality of nano-structures 9 having spring shapes densely.

According to this example, the nano-structure layer 7 is included in each of the plurality of flip-chip bonding portions, so that a thermal deformation difference of the semiconductor chip 1 and the package substrate 263 can be absorbed by the nano-structure layer 7. Therefore, a flip-chip-type semiconductor device having high reliability can be provided.

In addition, according to this example, because the underfill resin 264 to seal the flip-chip bonding portions does not need to have a thermal deformation absorption function, a range of material choices of the underfill resin 264 is expanded. That is, because a material having ease of filling or high shock resistance at the time of sealing can be selected as the material of the underfill resin 264, a flip-chip-type semiconductor device having higher reliability can be provided. In addition, the underfill resin 264 may not be filled into the gaps of the flip-chip bonding portions by giving the thermal deformation absorption function to the nano-structure layer 7.

The invention accomplished by the inventors has been specifically described on the basis of the embodiment and of the examples.

Industrial Applicability

The present invention can be applied to reduction of thermal stress and improvement of heat radiation in a semiconductor device including a substrate and a semiconductor chip packaged on the substrate.

Claims

1.   A semiconductor device comprising a substrate and a semiconductor chip packaged on the substrate, wherein a first deformation absorption layer (2a) is formed on a top surface of the semiconductor chip (1) and a second deformation absorption layer (2b) is formed on a bottom surface of the semiconductor chip (1) between the semiconductor chip (1) and the substrate,
wherein, each of the first and second deformation absorption layers (2a, 2b) includes a nano-structure layer (7), formed by a plurality of two-dimensionally arranged nano-structures (9) having a cross-sectional shape with a diameter or a length of one side of less than 1 $\mu$m, and two plate layers (6, 8) with the nano-structure layer (7) inbetween,
wherein the nano-structure layer (7) and the two plate layers of the deformation absorption layers (2a, 2b) are laminated along the direction of the thickness of the semiconductor chip, and a second plate layer (8) of the two plate layers (6, 8) is formed on the surface of the semiconductor chip,
**characterized in that**
one end of each of the plurality of nano-structures (9) is connected to the first plate layer (6) and the other end of each of the plurality of nano-stuctures (9) is connected to the second plate layer (8), and each of the plurality of nano-structures (9) has a zigzag shape.

2.   The semiconductor device according to claim 1, wherein a plurality of nano-structure layers (9) are laminated with an intermediate plate layer arranged therebetween.

Patentansprüche

1.   Halbleitervorrichtung, die ein Substrat und einen auf dem Substrat montierten Halbleiterchip umfasst, wobei eine erste Verformungsaufnahmeschicht (2a) auf einer oberen Oberfläche des Halbleiterchips (1) gebildet ist und eine zweite Verformungsaufnahmeschicht (2b) auf einer unteren Oberfläche des Halbleiterchips (1) zwischen dem Halbleiterchip (1) und dem Substrat gebildet ist,

wobei sowohl die erste als auch die zweite Verformungsaufnahmeschicht (2a, 2b) eine Nanostrukturschicht (7), die durch mehrere zweidimensional angeordnete Nanostrukturen (9) gebildet ist, die eine Querschnittsform mit einem Durchmesser oder einer Seitenlänge von weniger als 1 $\mu$m besitzen, und zwei Plattenschichten (6, 8), zwischen denen die Nanostrukturschicht (7) vorhanden ist, umfasst,

wobei die Nanostrukturschicht (7) und die beiden Plattenschichten der Verformungsaufnahmeschichten (2a, 2b) in Richtung der Dicke des Halbleiterchips laminiert sind und eine zweite Plattenschicht (8) der beiden Plattenschichten (6, 8) auf der Oberfläche des Halbleiterchips gebildet ist,

**dadurch gekennzeichnet, dass**

ein Ende jeder der mehreren Nanostrukturen (9) mit der ersten Plattenschicht (6) verbunden ist und das andere Ende jeder der mehreren Nanostrukturen (9) mit der zweiten Plattenschicht (8) verbunden ist und jede der mehreren Nanostrukturen (9) zickzackförmig ist.

2. Halbleitervorrichtung nach Anspruch 1, wobei mehrere Nanostrukturen (9) mit einer Zwischenplattenschicht, die dazwischen angeordnet ist, laminiert sind.

**Revendications**

1. Dispositif semi-conducteur comprenant un substrat et une puce semi-conductrice encapsulée sur le substrat,

dans lequel une première couche d'absorption de déformation (2a) est formée sur une surface supérieure de la puce semi-conductrice (1) et une seconde couche d'absorption de déformation (2b) est formée sur une surface inférieure de la puce semi-conductrice (1) entre la puce semi-conductrice (1) et le substrat,

dans lequel chacune des première et seconde couches d'absorption de déformation (2a, 2b) comprend une couche de nanostructures (7) formée par une pluralité de nanostructures (9) disposées de manière bidimensionnelle et ayant une forme en section transversale avec un diamètre ou une longueur d'un côté de moins de 1 $\mu$m et deux couches de plaque (6, 8) avec la couche de nanostructures (7) entre elles,

dans lequel la couche de nanostructures (7) et les deux couches de plaque des couches d'absorption de déformation (2a, 2b) sont stratifiées dans la direction de l'épaisseur de la puce semi-conductrice et une seconde couche de plaque (8) des deux couches de plaque (6, 8) est formée sur la surface de la puce semi-conductrice,

**caractérisé en ce que**

une extrémité de chacune de la pluralité de nanostructures (9) est reliée à la première couche de plaque (6) et l'autre extrémité de chacune de la pluralité de nanostructures (9) est reliée à la seconde couche de plaque (8), et

chacune de la pluralité de nanostructures (9) présente une forme en zigzag.

2. Dispositif semi-conducteur selon la revendication 1, dans lequel une pluralité de couches de nanostructures (9) sont stratifiées avec une couche de plaque intermédiaire disposée entre elles.

# FIG. 1

INNER PORTION OF FRAME IS ENLARGED AND ILLUSTRATED

# FIG. 2

*(a)*

*(b)*

INNER PORTION OF FRAME IS ENLARGED AND ILLUSTRATED

# FIG. 3

OVERALL VIEW
END ENLARGED VIEW
1
(a)

8
OVERALL VIEW
END ENLARGED VIEW
1
8
(b)

ROTATION
33
7
9   9   9
7
1
8
OVERALL VIEW
END ENLARGED VIEW
(c)

34
6
6
7   2a
8
1
OVERALL VIEW
END ENLARGED VIEW
(d)

2a
1
2b
(e)

EP 2 775 511 B1

FIG. 4

17

## FIG. 5

*(a)*

MICRO-SPRING

WIRE DIAMETER d1 = 10 um
NUMBER n = 1

*(b)*

NANO-SPRING

WIRE DIAMETER d0 = 0.01 um
NUMBER n = 1

*(c)*

NANO-SPRING LAYER

WIRE DIAMETER d0 = 0.01 um
NUMBER n = 1000 × 1000

EP 2 775 511 B1

# FIG. 6

*(a)*

*(b)*

FORCED
DISPLACEMENT
TO TOP SURFACE
500 nm

THREE-DIRECTION TYING
IN PLANE OF TOP
SURFACE

1500 nm

PERFECT BOTTOM
SURFACE FIXATION

(a) STRESS ANALYSIS MODEL

(b) EXAMPLE OF DEFORMATION
VIEW AND STRESS DISTRIBUTION

## FIG. 7

## FIG. 8

# FIG. 9

## (a)

## (b)

## (c)

# FIG. 10

## (a)

## (b)

# FIG. 11

## (a)

COMPARATIVE EXAMPLE

## (b)

SECOND EXAMPLE

## (c)

THIRD EXAMPLE

## FIG. 12

## FIG. 13

25

# FIG. 14

99a 99b
141

(a) EMITTER/GATE TERMINAL SIDE

144

(b) COLLECTOR TERMINAL SIDE

144

OVERALL VIEW (c)

144

END ENLARGED VIEW

1

ROTATION 33

7

9  9  9

144

7

1

OVERALL VIEW (d)

END ENLARGED VIEW

34

6

7

144

2b

6

1

OVERALL VIEW (e)

END ENLARGED VIEW

# FIG. 15

99a
99b

OVERALL VIEW (a)

99b 99a

1

END ENLARGED VIEW

99a
99b 151

2b

OVERALL VIEW (b)

151

1

END ENLARGED VIEW

ROTATION

33

7

1

OVERALL VIEW (c)

7

END ENLARGED VIEW

34

6

1

OVERALL VIEW (d)

6
7

END ENLARGED VIEW

1

OVERALL VIEW (e)

END ENLARGED VIEW

# FIG. 16

## (a)

## (b)

# FIG. 17

## (a)

## (b)

## FIG. 18

## FIG. 19

## FIG. 20

## FIG. 21

# FIG. 22

OVERALL VIEW   (a)   END ENLARGED VIEW

OVERALL VIEW   (b)   END ENLARGED VIEW

OVERALL VIEW   (c)   END ENLARGED VIEW

FIG. 23

# FIG. 24

8

OVERALL VIEW

END ENLARGED VIEW

(a)

33

9

OVERALL VIEW

END ENLARGED VIEW

(b)

16

9

OVERALL VIEW

END ENLARGED VIEW

(c)

14

6

OVERALL VIEW

END ENLARGED VIEW

(d)

# FIG. 25

# FIG. 26

## (a)

*1*

*264*

*263*

## (b)

INNER PORTION OF FRAME IS ENLARGED AND ILLUSTRATED

*1*

*261*

*9*

*264*

*7*

*6*

*3*

*262*

*263*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006287091 A
- JP 2003188209 A
- JP 2003298012 A
- US 2010196659 A1
- US 2006279932 A1
- US 6411513 B1
- US 2002159236 A1
- US 2005087881 A1

### Non-patent literature cited in the description

- **SUMIGAWA T.** Disappearance of stress singularity at interface edge due to anostructured thin film. *Engineering Fracture Mechanics,* 2008, vol. 75, 3073-3083
- The society of materials science, Databook on fatigue strength of metallic materials. Elsevier Science, 1996